# EUROPÄISCHE PATENTSCHRIFT

(11) **EP 1 462 538 B1**
(45) Veröffentlichungstag und Bekanntmachung des Hinweises auf die Patenterteilung: **10.05.2006**
(21) Anmeldenummer: 04003122.1
(22) Anmeldetag: 12.02.2004
(51) Int. Cl.: C23C 14/00, C23C 14/35

(54) **Verfahren zum reaktiven Magnetron-sputtern**
Reactive mangnetron sputtering method
Procédé de pulvérisation au magnétron réactif

(30) Priorität: 15.03.2003 DE 10311466
(43) Veröffentlichungstag der Anmeldung: 29.09.2004
(73) Patentinhaber: Fraunhofer-Gesellschaft zur Förderung der angewandten Forschung e.V., 80686 München (DE)
(72) Erfinder: Goedicke, Klaus, 01307 Dresden (DE); Fietzke, Fred, Dr., 01728 Hänichen (DE); Klostermann, Heidrun, Dr., 01326 Dresden (DE); Wünsche, Tilo, Dr., 01127 Dresden (DE)

(56) Entgegenhaltungen:
- EP-A- 0 328 257
- EP-A- 0 790 326
- DE-A- 19 535 845
- SAFI I: "Recent aspects concerning DC reactive magnetron sputtering of thin films: a review" SURF. COAT. TECHNOL. (SWITZERLAND), SURFACE AND COATINGS TECHNOLOGY, 22 MAY 2000, ELSEVIER, SWITZERLAND, Bd. 127, Nr. 2-3, 22. Mai 2000 (2000-05-22), Seiten 203-219, XP002287477 ISSN: 0257-8972

## Beschreibung

Die Erfindung betrifft ein Verfahren zur reaktiven Abscheidung dünner Schichten aus chemischen Verbindungen durch Magnetron-Sputtern auf Substraten, die während der Beschichtung an Beschichtungseinrichtungen vorbei geführt werden. Solche Verfahren können Anwendung finden für das Aufbringen optischer, dekorativer, harter, verschleißmindernder und anderer oberflächenverbessernder Beschichtungen auf unterschiedliche Substrate.

Es ist zur Abscheidung dünner Schichten durch Magnetron-Sputtern allgemein bekannt, die Substrate zur Erzielung einer gleichmäßigen Schicht ausreichender Dicke im Verlaufe der Beschichtung an Beschichtungseinrichtungen, wie Magnetron-Quellen, vorbei zu führen. Dieser Prozess kann mehrfach, vorzugsweise periodisch, wiederholt werden. Dazu werden sie auf Trägern linear bewegt oder auf Drehkörben oder Drehtellern einachsig oder mehrachsig rotierend gehaltert. Sollen Schichten aus Verbindungen mit definierter chemischer Zusammensetzung bei möglichst hoher Rate abgeschieden werden, so werden vorteilhafterweise metallische Targets in einem reaktiven Gasgemisch gesputtert. Durch Reaktion des Reaktivgases mit der Targetoberfläche tritt dabei eine teilweise Bedeckung der Targets mit Reaktionsprodukten als störende Begleiterscheinung auf. Sie wirkt sich in dem als "Targethysterese" bekannten Verhalten aus - vergleiche z. B. [S. Berg et al., J. Vac. Sci. Technol. A 5 (2)1987, 202-207].
Im sogenannten "metallic mode" werden unterstöchiometrische Schichten mit unerwünschten Eigenschaften bei vergleichsweise hoher Rate abgeschieden. Im sogenannten "compound mode" entstehen Schichten der gewünschten Zusammensetzung, jedoch mit meist drastisch reduzierter Rate. So verringert sich z. B. beim reaktiven Sputtern von stöchiometrischem Aluminiumoxid die Rate im Vergleich zur Abscheidung metallischer Schichten um mehr als eine Größenordnung.
Um den sprunghaften Übergang vom "metallic mode" in den "compound mode" und zurück zu vermeiden, muss der reaktive Sputterprozess durch eine Regelung der Reaktivgaszufuhr in einem als "Arbeitspunkt" bezeichneten Status stabilisiert werden. Dazu sind verschiedene Verfahren bekannt, die beispielsweise in [I. Safi, Surface and Coatings Technology 127 (2000) 203-219] beschrieben sind. Die Wahl des geeigneten Arbeitspunktes erfolgt so, dass die gewünschte Schichtzusammensetzung gesichert ist und dabei eine möglichst hohe Rate erreicht wird. Häufig entspricht die gewünschte Schichtzusammensetzung der durch die Stöechiometrie der abzuscheidenden Schichten vorgegebenen anteilsmäßigen Zusammensetzung aus einzelnen Beschichtungskomponenten, meist nach deren reaktiver Umsetzung. Sollen darüber hinaus spezielle Schichteigenschaften, z. B. eine hohe Verdichtung der Schicht oder eine vorgegebene Kristallstruktur erzeugt werden, so muss die Schicht oftmals an einem Arbeitspunkt abgeschieden werden, der einem wesentlich reaktiveren Status des Prozesses entspricht. Damit ist unvorteilhafterweise eine besonders niedrige Rate verbunden. Ganz allgemein ist die Regelung des reaktiven Magnetron-Sputterprozesses mit einem erheblichen Bedarf an Know-how sowie an Steuerungstechnik und Sensorik für die Prozessregelung verbunden und damit relativ aufwendig und störungsanfällig.

Es ist deshalb vorgeschlagen worden, die reaktive Abscheidung von Verbindungsschichten in zwei aufeinander folgenden Prozessschritten in zwei physisch voneinander getrennten Arbeitsstationen vorzunehmen (US 4,851,095). Dabei wird mit einer Magnetron-Quelle ein Material in einem Inertgas zerstäubt und als metallische Schicht auf vorbeibewegten Substraten abgeschieden. In einer physisch beabstandeten, mit Reaktivgas gefüllten Arbeitsstation wird ein dichtes Plasma erzeugt, welches eine Umwandlung der Schicht durch eine chemische Reaktion an der Oberfläche der Substrate bewirkt. Die Substrate werden wechselweise mehrfach durch beide Arbeitsstationen bewegt, bis eine Schicht ausreichender Dicke erzeugt ist. Weitere Ausgestaltungen dieses Prinzips finden sich in den Patentschriften US 5,225,057; US 5,618,388; US 5,660,693; US 5,798,027; US 5,879,519; US 6,090,247; EP 0 328 257 A2; EP 0 428 358 A2; EP 0 655 515 A1 und EP 0 699 246 B1. Allen diesen Verfahrensvarianten ist gemeinsam, dass aus prozesstechnischen Gründen eine Gastrennung zwischen den Arbeitsstationen gewährleistet sein muss. Dazu ist gerätetechnischer Aufwand und die Installation zusätzlicher Vakuumpumpen erforderlich. Die Anwendung ist außerdem auf ebene Substrate oder Substrate auf weitgehend ebenen oder zylinderförmigen Trägern beschränkt, um die Gastrennung sicherzustellen. Eine allseitige Beschichtung mehrachsig rotierender Substrate in ausgedehnten Substratanordnungen, z. B. Werkzeuge, ist auf diese Weise nicht möglich. Schließlich werden auch Defizite der Schichtqualität beobachtet, insbesondere bei höherer Abscheiderate. Sie beruhen offensichtlich auf Volumenänderungen, inneren Spannungen und anderen Erscheinungen, die mit der Stoffumwandlung der zunächst nichtreaktiv abgeschiedenen Teilschichten zusammenhängen.

Gemäß EP 0 605 299 A1 ist auch ein Verfahren zum reaktiven Zerstäuben eines Targets mit niederfrequent modulierter Gleichspannung vorgeschlagen worden. Dieses Verfahren hat sich in der industriellen Praxis nicht durchsetzen können - es ist offensichtlich nur für sehr geringe Targetleistungen geeignet und erlaubt nur geringe Abscheideraten und die Beschichtung kleiner Flächen.

Es besteht deshalb die Aufgabe, ein verbessertes Verfahren zur reaktiven Abscheidung dünner Schichten aus chemischen Verbindungen durch Magnetron-Sputtern zumindest für solche Prozesse anzugeben, bei denen die Substrate im Verlaufe der Beschichtung an Beschichtungseinrichtungen vorbei geführt werden. Insbesondere soll dabei unter Gewährleistung der gewünschten Schichteigenschaften eine hohe Abscheiderate erreicht werden.

Die Aufgabe wird durch ein Verfahren mit Merkmalen entsprechend Anspruch 1 gelöst. Die Ansprüche 2 bis 12 beschreiben zweckmäßige Ausgestaltungen des erfindungsgemäßen Verfahrens.

Die Erfindung beinhaltet den gleichzeitigen Betrieb mehrerer Magnetron-Entladungen bei verschiedenen Arbeitspunkten. Die Beschichtung der Substrate erfolgt, indem die Substrate während der Entladungen an den Magnetrons vorbei geführt werden. Das erfolgt vorteilhafterweise mehrfach, häufig auch periodisch. Gleichzeitigkeit im Sinne der Erfindung umfasst auch eine Quasigleichzeitigkeit, wenn zumindest Spezies aus Entladungsplasmen, die bei unterschiedlichen Arbeitspunkten betrieben werden, teilweise miteinander wechselwirken können. Periodisches Vorbeiführen im Sinne der Erfindung bedeutet auch das einmalige Vorbeiführen der Substrate an einer periodischen Anordnung von Beschichtungseinrichtungen, beispielsweise einer linearen Mehrfachanordnung von Magnetrons, deren Arbeitspunkte in Durchlaufrichtung alternierend eingestellt werden.

Überraschenderweise hat sich gezeigt, dass ein Betreiben des reaktiven Sputterprozesses durch gleichzeitigen Betrieb einer niederimpedanten und einer höherimpedanten Magnetron-Entladung insgesamt eine nennenswerte Erhöhung der Abscheiderate im Vergleich zum konventionell geregelten Betrieb zweier reaktiver Magnetron-Entladungen im gleichen Arbeitspunkt ermöglicht, ohne dass Einbußen bei den Schichteigenschaften hingenommen werden müssen. Der Arbeitspunkt bei konventioneller Regelung ist dabei durch die Impedanz gekennzeichnet, bei deren Konstanthaltung sich die gewünschte Schichtzusammensetzung erzielen lässt.
Möglicherweise liefert bei dem erfindungsgemäßen Betrieb der Magnetrons bei unterschiedlichen Impedanzen die niederimpedante Entladung einen hohen Anteil an energiereichen Spezies und Ladungsträgern und löst Elementarprozesse der Aktivierung und chemischen Reaktion bei der Schichtbildung auf der Substratoberfläche aus, so dass in der höherimpedanten Entladung das schichtbildende Material mit einer sehr hohen Rate abgeschieden und auf der Substratoberfläche mit der erforderlichen Reaktionskinetik umgewandelt werden kann. Die Ströme schichtbildender Partikel, Ladungsträger und weiterer energiereicher Spezies aus den Plasmen beider Entladungen können einander ungehindert durchdringen und miteinander sowie mit der Substratoberfläche wechselwirken.
Charakteristisch für das erfindungsgemäße Verfahren ist weiterhin, dass sowohl die höherimpedante als auch die niederimpedante Magnetron-Entladung gemeinsam ohne Gastrennung in einem einheitlichen Prozessraum betrieben werden. Eine Separation einzelner Arbeitsstationen ist nicht vorgesehen. Damit entfallen alle Einschränkungen in Bezug auf Art und Gestalt der Substrate, wie sie bei Verfahren mit getrennten Arbeitsstationen entsprechend dem Stand der Technik bestehen. Es sind keine Maßnahmen zur Schleusung der Substrate zwischen einzelnen Arbeitsstationen erforderlich, was eine Verminderung des technischen Aufwandes bedingt.

Besonders vorteilhaft ist es, die Arbeitspunkte der Magnetron-Entladungen so zu legen, dass sie außerhalb des Hysteresebereiches der jeweiligen Kennlinie des reaktiven Sputterprozesses liegen. Das bewirkt eine erhebliche Vereinfachung der Prozessführung gegenüber einem reaktiven Magnetron-Sputterprozess, der durch aktive Regelung am "Arbeitspunkt" stabilisiert werden muss. Dadurch sind wesentlich geringere Aufwendungen für Komponenten zur Prozessregelung erforderlich, und das notwendige Prozess-Know-how ist drastisch reduziert. Es wird eine wesentlich höhere Prozesssicherheit erreicht, insbesondere, wenn mit fest eingestellten Gasflüssen gearbeitet werden kann.

Besonders vorteilhaft und vielseitig einsetzbar ist das erfindungsgemäße Verfahren, wenn mindestens eine der Magnetron-Entladungen gepulst betrieben wird, wobei die Frequenz im Bereich von 1 bis 200 kHz liegen sollte. Sollen elektrisch isolierende Verbindungsschichten auf den Substraten abgeschieden werden, so muss zumindest die niederimpedante Entladung gepulst betrieben werden, um elektrische Durchbrüche ("arcing") an den mit isolierenden Schichten bedeckten Teilen der Targets und anderer Teile der Beschichtungsanordnung zuverlässig zu unterbinden.

Es kann zweckmäßig sein, dass mindestens eine der Magnetron-Entladungen in an sich bekannter Weise unipolar gepulst betrieben wird. Für diese Entladung sollte der niederimpedante Arbeitspunkt eingestellt werden. Diese Entladung kann vorteilhafterweise mit einer durch Gleichstrom gespeisten Entladung kombiniert werden. Hierzu wird beispielsweise ein weiteres Target durch eine Gleichstromversorgung gespeist und an dem höherimpedanten Arbeitspunkt betrieben.
Besonders für einen langzeitig stabilen Prozess ist es zweckmäßig, wenn mindestens eine der Magnetron-Entladungen, vorzugsweise mindestens die niederimpedante Entladung, zwischen zwei Targets bipolar gepulst betrieben wird. Wird mehr als eine Magnetron-Entladung auf diese Weise bipolar gepulst betrieben, dann kann vorteilhafterweise jeweils zwischen zwei Targets, die abwechselnd als Katode und Anode wirken, eine Pulsstromversorgung geschaltet werden. Dabei werden eine der Magnetron-Entladungen mit hoher Impedanz und eine andere Magnetron-Entladung mit niedriger Impedanz betrieben.
Das erfindungsgemäße Verfahren kann auch mit einem einzigen Paar von Targets bipolar gepulst betrieben werden, wenn Mittel zur stromrichtungsabhängigen Impedanzänderung eingesetzt werden. In diesem Fall wird bei jedem Polungswechsel auch die Impedanz geändert, beispielsweise durch unterschiedliche Wahl der Länge positiver und negativer Pulse bei gleicher Ausgangsspannung eines spannungsgeführten Wechselrichters als Pulsstromversorgung.
Um Magnetron-Entladungen mit unterschiedlicher Impedanz in einem einheitlichen Prozessraum entsprechend der Erfindung einzustellen, kann zweckmäßigerweise die Entladungsspannung unterschiedlich gewählt werden. Bei gepulst betriebenen Magnetron-Entladungen stehen dazu zusätzlich oder alternativ weitere Einstellparameter zur Verfügung, insbesondere die Pulslängen, die Pulspausen und die Frequenzen.
Schließlich können Magnetron-Entladungen unterschiedlicher Impedanz im Sinne des erfindungsgemäßen Verfahrens auch durch geeignete Mittel zum Reaktivgaseinlass und dadurch gezielt hervorgerufene Unterschiede der lokalen Partialdrücke oder der Reaktivgasflüsse erzeugt werden. Eine besonders einfache Ausgestaltung besteht darin, den Gaseinlass nur vor einzelnen Targets vorzunehmen. Vor diesen stellen sich Bedingungen mit einem gegenüber dem restlichen Rezipientenvolumen erhöhten Druck ein. Vor anderen Targets brennt die Plasmaentladung in einem niedrigeren Druckbereich, der weitgehend durch die Pumpleistung des Vakuumsystems bestimmt wird. Auf diese Weise erzielt man auch ohne Gastrennung für die Durchführung des erfindungsgemäßen Verfahrens ausreichende Druck- und Impedanzunterschiede.

Insbesondere die Variation der Impedanz durch Änderung elektrischer Parameter ermöglicht es, bei nahezu gleichen Gasflüssen Entladungen unterschiedlicher Impedanz zu unterhalten. Dadurch entfällt ebenfalls die Notwendigkeit einer Gastrennung.

Die Erfindung wird anhand von Ausführungsbeispielen näher erläutert. Die zugehörigen Zeichnungen zeigen:
- Fig. 1: eine typische Kennlinie eines reaktiven Sputterprozesses,
- Fig. 2: eine Einrichtung zur Durchführung des erfindungsgemäßen Verfahrens, die einen unipolar gepulsten Betrieb eines Magnetrons realisiert,
- Fig. 3: eine Einrichtung zur Durchführung des erfindungsgemäßen Verfahrens, die einen bipolar gepulsten Betrieb von zwei Magnetron-Entladungen realisiert,
- Fig. 4: eine Einrichtung zur Durchführung des erfindungsgemäßen Verfahrens, die an einem Paar Magnetrons einen bipolar gepulsten Betrieb realisiert, der quasigleichzeitig bei zwei verschiedenen Arbeitspunkten erfolgt,
- Fig. 5: eine weitere Einrichtung zur Durchführung des erfindungsgemäßen Verfahrens, die einen bipolar gepulsten Betrieb von zwei Magnetron-Entladungen realisiert.

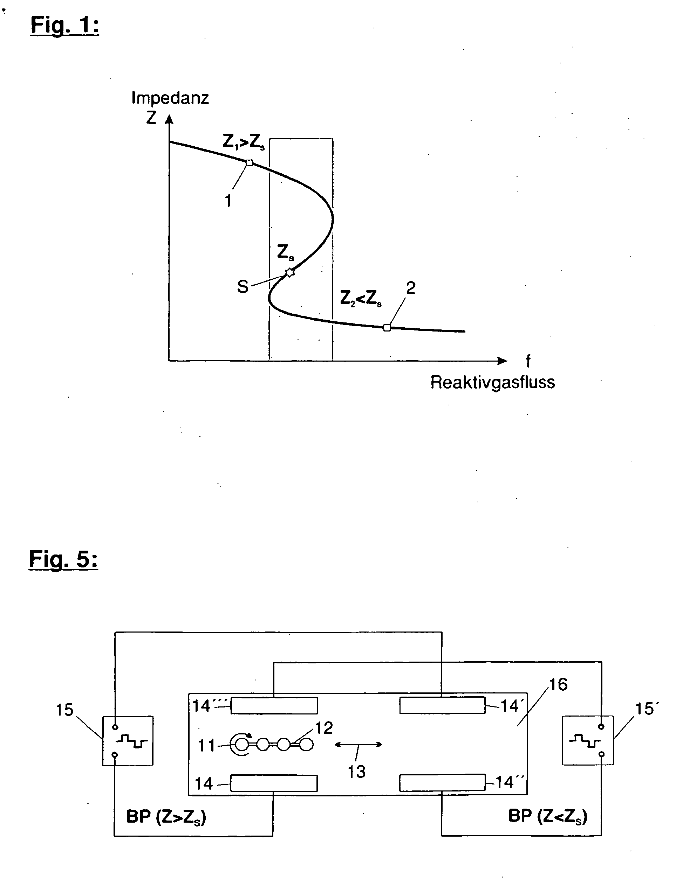

Figur 1 veranschaulicht das Wesen des erfindungsgemäßen Verfahrens im Vergleich zum Stand der Technik. Letzterer ist durch reaktives Sputtern von Targets mit aktiver Regelung im Arbeitspunkt S mit der Impedanz Z = Z_{S} charakterisiert. Dieser Arbeitspunkt liegt innerhalb des Hysteresebereiches der Magnetron-Entladungen. Entsprechend der Erfindung wird dagegen mindestens eine Magnetron-Entladung mit höherer Impedanz am Arbeitspunkt 1 mit Z₁ > Z_{S} und im gleichen Prozessraum mindestens eine weitere Magnetron-Entladung an einem anderen Arbeitspunkt 2 mit niedrigerer Impedanz Z₂ < Z_{S} betrieben. Die dargestellten Arbeitspunkte mit den Impedanzen Z₁ und Z₂ erlauben zudem einen besonders stabilen Betrieb ohne hohen Regelaufwand, da sie außerhalb des Hysteresebereiches liegen.

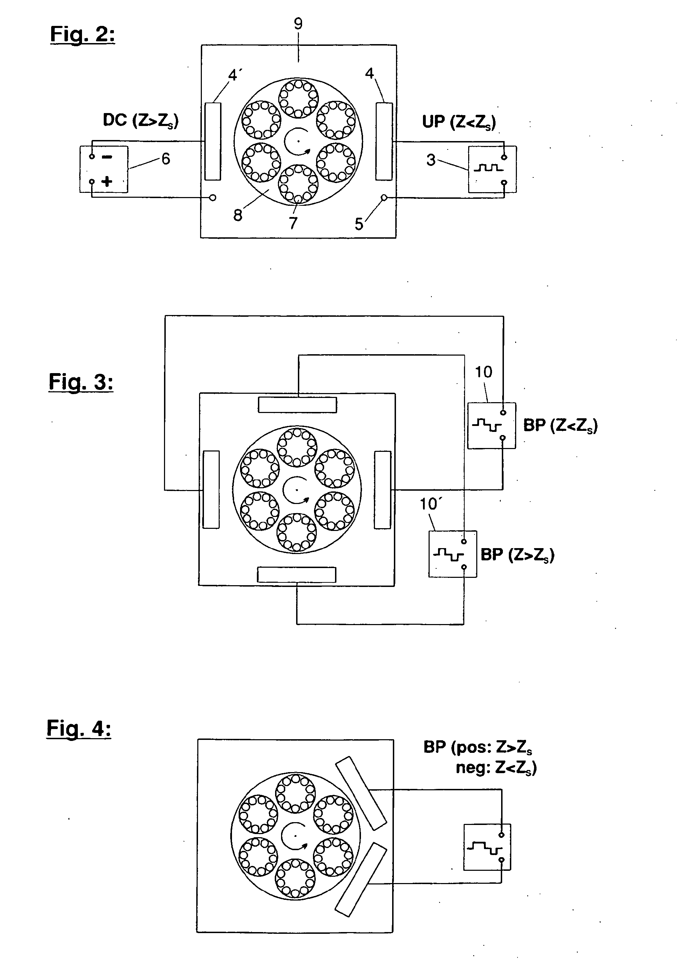

Fig. 2 zeigt eine Einrichtung zur Durchführung des erfindungsgemäßen Verfahrens, bei der eine der Magnetron-Entladungen unipolar gepulst betrieben wird. Dabei ist eine Pulsstromversorgung 3 zwischen ein Target 4 als Katode und eine geeignete zweite Elektrode 5 als Anode geschaltet. Für diese Entladung wird der niederimpedante Arbeitspunkt eingestellt. Ein weiteres Target 4' wird durch eine Gleichstromversorgung 6 gespeist und an dem höherimpedanten Arbeitspunkt betrieben. Substrate 7 sind auf einer mehrachsig rotierenden Plattform 8 innerhalb einer Vakuumkammer 9 zum Zwecke des Beschichtens angeordnet.

Fig. 3 zeigt eine Einrichtung zur Durchführung des erfindungsgemäßen Verfahrens, bei der zwei Magnetron-Entladungen bipolar gepulst betrieben werden. Zwei Pulsstromversorgungen 10, 10' sind jeweils zwischen zwei Targets geschaltet, die abwechselnd als Katode und Anode wirken. Dabei wird eine der Magnetron-Entladungen mit hoher Impedanz und die andere Magnetron-Entladung mit niedriger Impedanz betrieben. Durch eine kreuzweise Anordung der Magnetron-Paare wird eine vorteilhafte Durchdringung beider Entladungsplasmen bewirkt.

Fig. 4 zeigt eine Einrichtung zur Durchführung des erfindungsgemäßen Verfahrens, bei der quasigleichzeitig zwei Magnetron-Entladungen bipolar gepulst zwischen einem einzigen Magnetron-Paar betrieben werden. Eine spezielle Pulsquelle wird zur stromrichtungsabhängigen Impedanzänderung eingesetzt. Bei jedem Polungswechsel wird auch die Impedanz geändert, hier durch unterschiedliche Wahl der Länge positiver und negativer Pulse bei gleicher Ausgangsspannung eines spannungsgeführten Wechselrichters als Pulsstromversorgung. Damit hängt die jeweilige Impedanz der Plasmaentladung davon ab, welches Magnetron als Kathode und welches als Anode fungiert. Bei entsprechend schneller Pulsfolge treten ebenfalls die erfindungsgemäßen Effekte ein, obwohl stets nur eine der beiden Entladungen brennt.

Fig. 5 zeigt eine Einrichtung zur Durchführung des erfindungsgemäßen Verfahrens, bei der zwei Magnetron-Entladungen bipolar gepulst betrieben werden. Beispielhaft sollen Hartmetall-Stäbe 11 mit einem Überzug aus stöchiometrischem und darüber hinaus kristallinem Aluminiumoxid versehen werden. Die Stäbe 11 befinden sich auf einem Schlitten 12 in einer Vakuumkammer 16, die mit einem Vakuumerzeuger und Einrichtungen für den Einlass von Prozessgasen ausgestattet ist. Ein Antriebssystem bewirkt eine Rotation der Stäbe 11 um ihre Längsachse und eine Pendelbewegung des Schlittens 12 in Richtung 13. Innerhalb der Vakuumkammer 16 sind vier Magnetron-Quellen mit Aluminium-Targets 14 bis 14'" betreibbar. Zwei spannungsgeführte bipolare Pulsstromversorgungen 15, 15' sind derart zwischen je ein Paar von Magnetronquellen 14 und 14' bzw. 14" und 14'" geschaltet, dass diese Paare die Elektroden von bipolar gepulsten Magnetron-Entladungen bilden. Bei einem Druck von 0,5 Pa wird ein reaktives Gasgemisch aus 70 vol% Argon und 30 vol% Sauerstoff in die Vakuumkammer eingelassen. Beide Pulsstromversorgungen werden auf eine Entladungsleistung von 20 kW eingestellt. Zur Erzeugung von zwei Magnetron-Entladungen unterschiedlicher Impedanz wird die Pulsstromversorgung 15 bei einer Entladungsspannung von 900 V, einer Pulslänge von 15 µs und einer Pulspause von 5 µs betrieben, während die entsprechenden Parameter bei der Pulsstromversorgung 15' 500 V und jeweils 10 µs betragen. Auf diese Weise wird mit Hilfe der Pulsstromversorgung 15 eine höherimpedante Magnetron-Entladung und mit Hilfe der Pulsstromversorgung 15' eine niederimpedante Magnetron-Entladung erzeugt. Da beide Arbeitspunkte außerhalb des Hysteresebereiches liegen, sind außer dem Einlass konstanter Gasflüsse keine weiteren Maßnahmen zur Prozessstabilisierung erforderlich. Im Verlaufe des einstündigen Beschichtungsvorganges wird auf den Hartmetall-Stäben eine 4 µm dicke Schicht aus kristallinem Aluminiumoxid der γ-Modifikation abgeschieden. Damit ist bei unveränderter Schichtqualität die Abscheiderate um den Faktor 1,8 höher als bei einem durch aktive Regelung im Hysteresebereich stabilisierten Prozess entsprechend dem Stand der Technik.

## Patentansprüche

1. Verfahren zur reaktiven Abscheidung von Schichten aus chemischen Verbindungen durch Magnetron-Sputtern auf Substraten, die während der Beschichtung an Beschichtungseinrichtungen vorbei geführt werden, **dadurch gekennzeichnet, dass** mindestens zwei Magnetron-Entladungen gleichzeitig betrieben werden, derart, dass mindestens eine der Magnetron-Entladungen eine Impedanz größer als Z_{S} und mindestens eine der Magnetron-Entladungen eine Impedanz kleiner als Z_{S} aufweist, wobei Z_{S} diejenige Impedanz einer reaktiv betriebenen Magnetron-Entladung ist, die für die Abscheidung einer Schicht der gewünschten chemischen Zusammensetzung eingestellt werden muss.

2. Verfahren nach Anspruch 1, **dadurch gekennzeichnet, dass** die Substrate periodisch an Beschichtungseinrichtungen vorbei geführt werden.

3. Verfahren nach Anspruch 1 oder 2, **dadurch gekennzeichnet, dass** die Magnetron-entladungen mit gegenüber Z_{S} erhöhter bzw. verringerter Impedanz an Arbeitspunkten betrieben werden, die außerhalb des Hysteresebereiches des reaktiven Sputterprozesses liegen.

4. Verfahren nach mindestens einem der Ansprüche 1 bis 3, **dadurch gekennzeichnet, dass** mindestens die Magnetron-Entladung mit der niedrigeren Impedanz gepulst mit einer Frequenz im Bereich von 1 bis 200 kHz betrieben wird.

5. Verfahren nach mindestens einem der Ansprüche 1 bis 3, **dadurch gekennzeichnet, dass** mindestens eine der Magnetron-Entladungen unipolar gepulst zwischen dem Target und einer Zusatzelektrode betrieben wird.

6. Verfahren nach mindestens einem der Ansprüche 1 bis 3, **dadurch gekennzeichnet, dass** mindestens eine der Magnetron-Entladungen bipolar gepulst zwischen zwei Targets betrieben wird.

7. Verfahren nach Anspruch 6, **dadurch gekennzeichnet, dass** sowohl die gegenüber Z_{S} niederimpedanten als auch die höherimpedanten Magnetron-Entladungen zwischen den gleichen Targets oder Gruppen von Targets betrieben werden und die Impedanz jeweils mit dem Polungswechsel geändert wird.

8. Verfahren nach mindestens einem der Ansprüche 1 bis 7, **dadurch gekennzeichnet, dass** die Impedanz der Magnetron-Entladungen durch Einstellparameter der Stromversorgungseinrichtungen für die Magnetron-Entladungen wie elektrischer Strom oder elektrische Spannung und/oder das Verhältnis von Puls-Ein- zu Puls-Aus-Zeit kontrolliert wird.

9. Verfahren nach mindestens einem der Ansprüche 1 bis 7, **dadurch gekennzeichnet, dass** die Impedanz der Magnetron-Entladungen durch den Partialdruck und/oder den Fluss des Reaktivgases kontrolliert wird.

10. Verfahren nach mindestens einem der Ansprüche 1 bis 7, **dadurch gekennzeichnet, dass** die Impedanz der Magnetron-Entladungen durch Einstellparameter der Stromversorgungseinrichtungen für die Magnetron-Entladungen wie elektrischer Strom oder elektrische Spannung und/oder das Verhältnis von Puls-Ein- zu Puls-Aus-Zeit und durch den Partialdruck und/oder den Fluss des Reaktivgases kontrolliert wird.

11. Verfahren nach einem der Ansprüche 1 bis 10, **dadurch gekennzeichnet, dass** ein konstanter Gaseinlass erfolgt.

12. Verfahren nach einem der Ansprüche 1 bis 11, **dadurch gekennzeichnet, dass** ein konstanter Gaseinlass unmittelbar vor einzelnen Targets erfolgt.

## Claims

1. A method for the reactive separation of coats of chemical compounds by magnetron sputtering on substrates which are guided past coating devices during coating, **characterised in that** at least two magnetron discharges are operated simultaneously so that at least one of the magnetron discharges has an impedance greater than Zₛ and at least one of the magnetron discharges has an impedance smaller than Zₛ, wherein Zₛ is the impedance of a reactively operated magnetron discharge which must be set for separating a coat with the desired chemical composition.

2. The method according to Claim 1, **characterised in that** the substrates are guided periodically past coating devices.

3. The method according to Claim 1 or 2, **characterised in that** the magnetron discharges are operated with an impedance that is increased or reduced relative to Zₛ at working points which lie outside the hysteresis range of the reactive sputtering process.

4. The method according to at least one of Claims 1 to 3, **characterised in that** at least the magnetron discharge is operated with the lower impedance pulsed with a frequency in the range of 1 to 200 kHz.

5. The method according to at least one of claims 1 to 3, **characterised in that** at least one of the magnetron discharges is operated pulsed unipolarly between the target and an additional electrode.

6. The method according to at least one of Claims 1 to 3, **characterised in that** at least one of the magnetron discharges is operated pulsed unipolarly between two targets.

7. The method according to Claim 6, **characterised in that** both the both the magnetron discharges with a lower and higher impedance than Zₛ are operated between the same targets or groups of targets and **in that** the impedance is varied when the polarity is changed.

8. The method according to at least one of Claims 1 to 7, **characterised in that** the impedance of the magnetron discharges is controlled by setting parameters of the power supply devices for the magnetron discharges, such as electrical current or electrical voltage and/or the pulse in to pulse out ratio.

9. The method according to at least one of Claims 1 to 7, **characterised in that** the impedance of the magnetron discharges is controlled by the partial pressure and/or the flow of the reactive gas.

10. The method according to at least one of Claims 1 to 7, **characterised in that** the impedance of the magnetron discharges is controlled by setting parameters of the power supply devices for the magnetron discharges, such as electrical current or electrical voltage and/or the pulse in to pulse out time ratio and by the partial pressure and/or the flow of the reactive gas.

11. The method according to any one of Claims 1 to 10, **characterised in that** the gas is admitted constantly.

12. The method according to any one of Claims 1 to 11, **characterised in that** gas is admitted constantly and immediately in front of individual targets.

## Revendications

1. Procédé de dépôt réactif de couches de composés chimiques par pulvérisation au magnétron sur des substrats, qui, pendant le revêtement, passent devant des installations de revêtement,
**caractérisé en ce qu'**
on met en oeuvre au moins deux décharges magnétron sont exercées simultanément, de sorte qu'au moins une des décharges magnétron présente une impédance supérieure à Zs et au moins une des décharges magnétron présente une impédance inférieure à Zs, Zs étant l'impédance d'une décharge magnétron exercée de façon réactive à établir pour le déposer une couche de la composition chimique souhaitée.

2. Procédé selon la revendication 1,
**caractérisé en ce qu'**
on fait passer les substrats périodiquement devant des installations de revêtement.

3. Procédé selon la revendication 1 ou 2,
**caractérisé en ce que**
on exerce les décharges magnétron avec une impédance réduite ou accrue par rapport à Zs à des points de travail situés en dehors de la plage d'hystérésis du processus de pulvérisation réactif.

4. Procédé selon au moins une des revendications 1 à 3,
**caractérisé en ce qu'**
on exerce au moins la décharge magnétron d'impédance la plus faible pulsée à une fréquence située dans la plage de 1 à 200 kHz.

5. Procédé selon au moins une des revendications 1 à 3,
**caractérisé en ce qu'**
on exerce au moins l'une des décharges magnétron pulsée de manière unipolaire entre la cible et une électrode supplémentaire.

6. Procédé selon au moins une des revendications 1 à 3,
**caractérisé en ce qu'**
on exerce au moins l'une des décharges magnétron pulsée de manière bipolaire entre deux cibles.

7. Procédé selon la revendication 6,
**caractérisé en ce qu'**
on exerce les décharges magnétron de faible impédance par rapport à Zs ainsi que les décharges magnétron d'impédance plus élevée entre les mêmes cibles ou groupes de cibles, et on modifie l'impédance à chaque changement de polarité.

8. Procédé selon au moins une des revendications 1 à 7,
**caractérisé en ce qu'**
on contrôle l'impédance des décharges magnétron par des paramètres de réglage des installations d'alimentation électrique destinées aux décharges magnétron tels que le courant électrique ou la tension électrique et/ou le rapport entre le temps d'impulsion et le temps de repos.

9. Procédé selon au moins une des revendications 1 à 7,
**caractérisé en ce qu'**
on contrôle l'impédance des décharges magnétron par la pression partielle et/ ou le flux du gaz réactif.

10. Procédé selon au moins une des revendications 1 à 7,
**caractérisé en ce que**
on contrôle l'impédance des décharges magnétron par des paramètres de réglage des installations d'alimentation électrique destinées aux décharges magnétron tels que le courant électrique ou la tension électrique et/ou le rapport entre le temps d'impulsion et le temps de repos et par la pression partielle et/ou le flux du gaz réactif.

11. Procédé selon au moins une des revendications 1 à 10,
**caractérisé en ce qu'**
on produit une entrée constante de gaz.

12. Procédé selon au moins une des revendications 1 à 11,
**caractérisé en ce qu'**
on produit une entrée constante de gaz directement devant les diverses cibles.
